# FASCICULE DE BREVET EUROPEEN

(11) **EP 0 825 913 B1**
(45) Date de publication et mention de la délivrance du brevet: **13.01.1999**
(21) Numéro de dépôt: 96916211.4
(22) Date de dépôt: 17.05.1996
(51) Int. Cl.: B23P 19/00, H01H 13/70, H05K 13/04

(54) **PROCEDE ET APPAREIL DE FABRICATION D'ARTICLES CONTENANT DES PIECES PLATES**
VERFAHREN UND VORRICHTUNG ZUR HERSTELLUNG VON ARTIKELN MIT FLÄCHIGEN TEILEN
METHOD AND APPARATUS FOR MAKING ARTICLES CONTAINING FLAT PIECES

(30) Priorité: 18.05.1995 FR 9505930
(43) Date de publication de la demande: 04.03.1998
(73) Titulaire: NICOMATIC, 74890 Bons-en-Chablais (FR)
(72) Inventeur: GIRARD, Abel, F-74160 Archamps (FR); FERROUD-PLATTET, Fernand, F-74160 Saint-Julien-en-Genevois (FR)
(74) Mandataire: Arnaud, Jean Pierre Alfred
(86) Numéro de dépôt international: FR9600742
(87) Numéro de publication internationale: WO9636457

(56) Documents cités:
- DE-A- 2 908 960
- GB-A- 2 056 956
- US-A- 4 153 987
- PATENT ABSTRACTS OF JAPAN vol. 5, no. 203 (M-103), 23 Décembre 1981 & JP,A,56 119339 (MATSUSHITA), 18 Septembre 1981,
- PATENT ABSTRACTS OF JAPAN vol. 16, no. 37 (E-1160), 29 Janvier 1992 & JP,A,03 246835 (FUJIKURA LTD), 5 Novembre 1991,
- PATENT ABSTRACTS OF JAPAN vol. 16, no. 312 (E-1230), 9 Juillet 1992 & JP,A,04 087225 (TEIKOKU TSUSHIN KOGYO CO LTD), 19 Mars 1992,
- PATENT ABSTRACTS OF JAPAN vol. 9, no. 87 (M-372), 17 Avril 1985 & JP,A,59 214525 (FUJITSU K.K.), 4 Décembre 1984,

## Description

La présente invention concerne un procédé de fabrication d'articles ayant un arrangement de pièces plates et un appareil de positionnement automatique de pièces plates.

L'invention s'applique à la fabrication d'articles comprenant un arrangement de pièces plates réalisées par des étapes de découpe et de mise en forme d'un matériau en feuille. Les articles les plus courants de ce type sont les claviers, par exemple les claviers des téléphones mobiles, qui comportent, pour chaque touche, un dôme métallique placé sur un circuit imprimé. Pour cette raison, dans la description qui suit, on considère essentiellement que ces articles sont des claviers, et que les pièces plates sont des dômes utilisés chacun pour une touche de clavier.

La demande de brevet EP-A-0 800 426 (WO-A-96/20799) déposée le 4 janvier 1995 pour un "procédé de fabrication de pièces plates, et pièces plates formées par sa mise en oeuvre" décrit des pièces plates qui ne peuvent pas se coller les unes aux autres, car elles possèdent une saillie dont la dimension est telle que le collage de deux pièces l'une à l'autre est impossible. Cette demande appartient à l'état de la technique visé à l'article 54(3) CBE.

L'invention met en oeuvre cette caractéristique pour la réalisation d'articles comprenant de telles pièces plates.

Une première caractéristique de l'invention est l'utilisation de tubes pour le positionnement d'une pile de pièces plates pour chaque position de l'arrangement de pièces plates.

On connaît déjà l'utilisation de tubes pour la présentation de composants électroniques destinés à être placés sur des cartes de circuit imprimé par exemple. De tels tubes présentent l'avantage de permettre la présentation d'un seul composant avec une orientation convenable à une ouverture de sortie du tube. Cependant, jusqu'à présent, l'utilisation de tels tubes n'a pas été réalisable efficacement avec des pièces plates telles que les dômes des claviers, car ces pièces plates se collent formes complémentaires et présentent fréquemment une adhérence de contact. Il suffit que, sur un clavier pouvant comprendre plusieurs dizaines de touches, deux pièces soient collées à un seul emplacement pour que le clavier doive être considéré comme défectueux et mis au rebut. Pour cette raison, il a été pratiquement impossible d'utiliser une alimentation par tube pour les pièces plates de la technique antérieure. Grâce aux pièces plates décrites dans la demande précitée de brevet français, il est maintenant possible d'utiliser le conditionnement des pièces plates en tubes.

Dans le cas des articles considérés, le conditionnement en tubes présente aussi un avantage supplémentaire. En effet, les dômes bombés utilisés dans la plupart des claviers doivent avoir une certaine orientation en rotation pour être positionnés dans des logements de configuration correspondante. Le conditionnement en tubes dont la section est complémentaire de la configuration périphérique des dômes permet une orientation précise des dômes qui peuvent être logés en toute sécurité.

Une autre caractéristique de l'invention est l'utilisation d'un gabarit qui reproduit, par les ouvertures de sortie de tubes contenant des pièces plates, la configuration que doivent avoir les pièces plates dans l'article terminé, ou une configuration inverse.

La demande de brevet britannique n° 2 056 956 décrit un appareil automatique de positionnement de pièces, sous forme de composants plats pour montage en surface, qui comporte un gabarit de positionnement de tubes contenant des pièces, un dispositif de poussée de pièce, et un dispositif de saisie, de déplacement et de libération de pièces.

L'invention concerne plus précisément un procédé de fabrication d'articles ayant un arrangement de pièces plates réalisées par des étapes de découpe et de mise en forme d'un matériau en feuille, chaque pièce plate comportant au moins une saillie destinée à empêcher le collage mutuel de deux pièces plates ; selon l'invention, le procédé comprend les étapes suivantes :
le logement des pièces plates dans des tubes de manière que, dans chaque tube, les pièces plates aient une même orientation dans le sens haut-bas et en rotation, chaque tube ayant une ouverture de sortie de pièce plate,
le positionnement de tubes contenant des pièces plates afin qu'ils soient parallèles les uns aux autres et que leurs ouvertures de sortie soient disposées avec l'arrangement voulu pour les pièces plates dans l'article à réaliser, chaque tube étant orienté en rotation de manière que, au niveau de l'ouverture de sortie, les pièces plates aient l'orientation qu'elles doivent avoir dans l'article terminé ou une orientation inverse,
la saisie simultanée de pièces plates par les ouvertures de sortie des tubes à raison d'une pièce plate par tube,
le déplacement des pièces plates saisies soit directement sur un élément de l'article à fabriquer, soit sur un organe intermédiaire, avec la disposition que les pièces plates doivent avoir dans l'article terminé ou une disposition inverse, et
la libération des pièces plates.

Dans un mode de réalisation, la disposition des pièces plates dans les tubes est réalisée dans des tubes de section complémentaire de la configuration périphérique des pièces plates de manière que toutes les pièces plates aient la même orientation dans le tube.

Dans un autre mode de réalisation, la disposition des pièces plates dans les tubes comprend leur disposition dans un tube de section circulaire dont le diamètre est légèrement supérieur au diamètre du cercle dans lequel s'inscrit la périphérie des pièces plates du tube, et un dispositif oriente les pièces plates à proximité de l'ouverture de sortie.

Dans un autre mode de réalisation, les pièces plates ont une symétrie de rotation autour d'un axe perpendiculaire à leurs grandes faces, et l'ouverture de sortie est circulaire.

Dans un mode de réalisation, chaque tube comprend des pièces plates d'un seul type, et tous les tubes contiennent des pièces plates du même type. Dans un autre mode de réalisation, chaque tube contient des pièces plates d'un seul type, mais des tubes différents contiennent des pièces plates de types différents.

De préférence, la saisie, le déplacement et la libération des pièces plates sont effectués par un dispositif à aspiration.

Dans un mode de réalisation, la libération des pièces plates est réalisée lorsque les pièces plates sont positionnées dans des logements prévus à cet effet dans l'article fabriqué. Dans un autre mode de réalisation, la libération des pièces plates est effectuée lorsque celles-ci ont été appliquées sur une surface de maintien des pièces places avec l'arrangement voulu ou l'arrangement inverse sur un dispositif de maintien. Dans ce dernier cas, il est avantageux que le dispositif de maintien fonctionne par aspiration ou par collage.

De préférence, le procédé comprend la libération des pièces plates sur un organe intermédiaire de retenue, et le procédé comporte en outre la vérification du positionnement des pièces plates sur l'organe de retenue avant leur disposition dans l'article terminé.

L'invention concerne aussi un appareil automatique de positionnement de pièces plates, destiné à la mise en oeuvre du procédé des paragraphes précédents, et qui comporte un gabarit de positionnement de tubes contenant des pièces plates, un dispositif de poussée de pièce plate, un dispositif de saisie, de déplacement et de libération de pièces plates, une tourelle à plusieurs faces, chaque face portant un dispositif de maintien de pièces plates avec l'arrangement voulu pour l'article terminé ou l'arrangement inverse, et un dispositif d'entraînement en rotation de la tourelle.

De préférence, l'organe de maintien de chaque face de la tourelle comporte un dispositif à aspiration ou un dispositif adhésif.

De préférence, l'appareil comporte en outre un dispositif de vérification du positionnement des pièces plates sur l'organe de maintien.

Dans un mode de réalisation, l'appareil comporte en outre un dispositif de manutention d'éléments d'article à fabriquer de manière que chaque article puisse occuper une position dans laquelle la tourelle permet l'introduction de l'arrangement de pièces plates dans l'élément.

D'autres caractéristiques et avantages de l'invention ressortiront mieux de la description qui va suivre d'exemples de réalisation, faite en référence aux dessins annexés sur lesquels :
les figures 1 et 2 sont des vues en plan de deux exemples de pièces plates constituant des dômes de clavier selon la demande précitée de brevet français ;
la figure 3 est une vue schématique en perspective d'un exemple d'appareil utilisé pour la mise en oeuvre du procédé de l'invention ; et
la figure 4 est une vue schématique en élévation latérale permettant la description d'une opération de l'appareil de la figure 3.

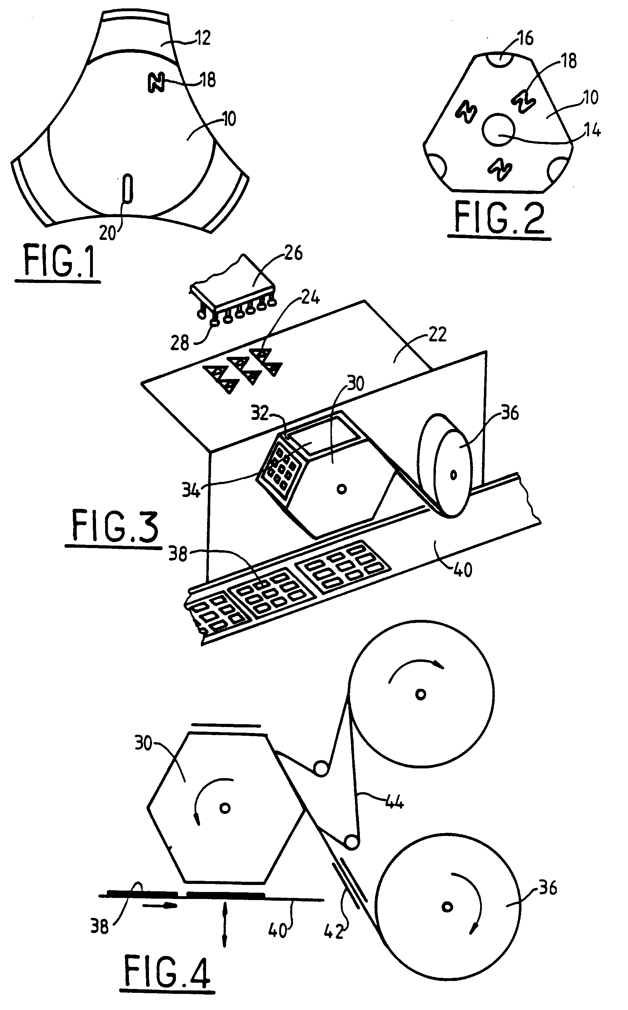

Les pièces plates sont des pièces plates qui, sur les figures 1 et 2, sont représentées sous forme de dômes de clavier. Ces dômes de clavier comportent un corps 10 qui, dans les exemples des figures 1 et 2, a une forme générale triangulaire et est éventuellement muni de bras élastiques 12 ou de déformations 14, 16 pour réaliser un contact tout en ayant une action élastique. Les pièces plates des figures 1 et 2 sont bombées et formées par découpe d'une feuille d'un métal élastique. Selon l'invention décrite dans la demande précitée de brevet, les pièces plates 10 ont des saillies 18, 20 qui empêchent le collage des pièces les unes aux autres.

Une caractéristique essentielle est que la cavité formée par les saillies 18, 20 est plus petite que la saillie elle-même de manière que celle-ci ne puisse pas pénétrer dans la cavité d'une autre pièce plate, l'emboîtement maximal de la saillie dans la cavité d'une pièce adjacente étant tel que, à proximité de la saillie et de la cavité, deux pièces adjacentes ayant des dimensions nominales soient séparées par un espace supérieur au double de la tolérance de dimension dans la direction de l'épaisseur, si bien que deux pièces plates quelconques comprises dans toute la plage de tolérances ne peuvent pas former de surface étendue de contact mutuel.

Ces caractéristiques des pièces plates décrites dans la demande précitée de brevet permettent la mise en oeuvre d'un procédé de fabrication d'articles, et notamment de claviers, d'une manière qui n'a pas été réalisable jusqu'à présent, à cause du collage trop fréquent des pièces plates constituant les dômes de claviers.

Ces caractéristiques des pièces plates permettent leur conditionnement en tubes dans lesquels les pièces sont accolées, avec la même orientation dans le sens haut-bas et en rotation, sans adhérence des pièces les unes aux autres. De tels tubes d'orientation de composants électroniques sont déjà connus pour des composants destinés à être positionnés sur des circuits imprimés, notamment pour le montage en surface. Ces composants électroniques ne risquent pas de se coller les uns aux autres et leur prélèvement dans des tubes, avec une orientation déterminée, ne pose pas de problème.

Cependant, ce conditionnement en tubes n'a pas pu être utilisé pour les dômes de claviers. En effet, si l'on essaie d'empiler les dômes de claviers en tubes, même si les dômes sont parfaitement propres et dépourvus de toute graisse pouvant provoquer un collage, les dômes identiques ont des surfaces étendues de contact si bien que, lorsqu'une pièce est prélevée en bout par aspiration, elle entraîne fréquemment une seconde et même souvent une troisième pièce plate. L'incorporation de deux ou trois dômes empilés à un emplacement de touche d'un clavier, bien qu'elle n'empêche parfois pas le fonctionnement de la touche, est tout à fait indésirable car la force qui doit être appliquée à la touche particulière est très différente de celle qui doit être appliqué aux touches voisines. En conséquence, un clavier dans lequel deux dômes sont empilés à la place d'un seul doit être considéré comme défectueux et mis au rebut.

Les dômes sont placés dans des tubes qui ont sur toute leur longueur une section de forme complémentaire de la configuration périphérique des pièces plates ; dans une variante, ils ont une section circulaire de diamètre légèrement supérieur au diamètre du cercle dans lequel s'inscrit la périphérie des pièces plates avec, à proximité de l'ouverture de sortie, un dispositif d'orientation des pièces plates.

Tous les tubes peuvent comporter des dômes identiques, par exemple lors de la réalisation d'un clavier alphanumérique. Ces dômes peuvent tous avoir la même orientation en rotation. Cependant, cette caractéristique n'est nullement indispensable. Par exemple, l'orientation en rotation des dômes peut être différente dans les différents tubes. En outre, dans certaines applications, l'orientation en rotation des dômes n'est pas nécessaire, et les tubes peuvent avoir simplement une section circulaire.

Il arrive aussi fréquemment que des claviers comportent plusieurs zones appelées "pavés" comprenant des touches dont les fonctions sont différentes. Ces touches peuvent même avoir des dimensions différentes. Dans ce cas, il est donc nécessaire que les pièces plates disposées dans des tubes différents ne soient pas du même type, et le procédé de l'invention permet l'utilisation sans difficulté de pièces de types différents.

Les tubes sont positionnés par un gabarit ou de toute autre manière voulue afin qu'il donne l'arrangement voulu des dômes dans le clavier à fabriquer. Les ouvertures de sortie des tubes forment donc un arrangement d'ouvertures permettant la saisie d'un dôme à chaque ouverture de sortie. Selon l'invention, un dôme est saisi à chaque ouverture de sortie, ces dômes étant saisis simultanément et étant ensuite déplacés. Les dômes sont déplacés soit sur un organe intermédiaire, soit directement dans un élément de l'article à fabriquer. En particulier, on peut envisager de déplacer directement les dômes dans des logements prévus à cet effet dans des éléments de clavier.

Cependant, il est préférable de réaliser un contrôle intermédiaire de la présence de tous les dômes. Comme ce contrôle n'est pas commode sur le dispositif de déplacement, il est avantageux que les dômes soient déplacés sur un organe intermédiaire qui les retient en position correspondant à l'arrangement dans l'article à fabriquer ou en position inverse. L'arrangement des dômes peut alors être contrôlé sur cet organe intermédiaire avant leur libération.

L'organe intermédiaire peut être un organe aspirant, par exemple d'une tourelle, ou un organe collant, comme décrit dans la suite en référence aux figures 3 et 4.

Les figures 3 et 4 représentent un exemple d'appareil. L'appareil comporte une partie supérieure 22 qui forme un gabarit destiné au positionnement des ouvertures de sortie des tubes 24, les tubes parallèles n'étant pas représentés car ils sont placés au-dessous de la plaque 22. Un poussoir introduit dans chaque tube repousse la pile de dômes afin que les parties supérieures des pilés de dômes contenues dans les tubes se trouvent au voisinage du plan de la face supérieure de la plaque 22. Les ouvertures 24 sont disposés avec l'arrangement voulu pour les dômes dans le clavier à réaliser. Ces orifices ne sont pas représentés à l'échelle sur la figure 3.

Un dispositif 26 d'aspiration comprenant des ventouses 28 vient saisir un dôme à chaque ouverture de sortie de tube au niveau de la plaque 22. Ensuite, le dispositif 26 est soulevé et déplacé afin qu'il vienne se positionner en regard d'une face 32 d'une tourelle hexagonale 30, portant un organe intermédiaire de maintien 34 sous forme d'un rectangle de ruban adhésif. Le dispositif 26 de saisie et de déplacement vient appliquer l'arrangement de dômes sur le ruban adhésif 34, avec la disposition voulue sur le morceau de ruban adhésif provenant du rouleau 36.

La tourelle tourne par pas pour présenter ses faces successivement au dispositif 26 de saisie et de déplacement. Lorsque l'arrangement de dômes a tourné de 60° ou de 120°, un dispositif de contrôle (non représenté) vérifie la position et l'orientation des dômes sur l'organe intermédiaire de maintien, avant que, lorsque la face est tournée vers le bas, un circuit imprimé 38 vienne s'appliquer contre la face de la tourelle 30 qui se trouve alors en bas et reçoive l'arrangement de dômes, soit seul, soit avec le ruban adhésif lorsque l'organe intermédiaire est formé d'un ruban adhésif. Un dispositif 40 de manutention permet le déplacement convenable du circuit imprimé 38.

Bien qu'on ait indiqué l'utilisation d'un circuit imprimé, il est évident que plusieurs circuits imprimés peuvent être placés les uns à côté des autres et peuvent recevoir simultanément des dômes. Par exemple, 120 dômes peuvent être placés simultanément sur six claviers à 20 dômes ou sur huit claviers à 15 dômes. Le nombre de dômes placés simultanément peut varier avec la nature du clavier et son nombre de touches, mais il est de préférence au moins égal au nombre total de dômes du clavier considéré.

La figure 4 représente en outre un dispositif 42 de coupe et un dispositif à courroie 44 destiné à appliquer des morceaux de ruban adhésif de la bobine 36 sur chacune des faces de la tourelle 30 successivement, pour la réalisation successive d'arrangements de dômes.

On a décrit, en référence aux figures 3 et 4, un appareil dans lequel une tourelle hexagonale tourne par pas de 60° et permet l'exécution successive de diverses étapes : application d'un ruban adhésif, application des dômes sur le ruban adhésif, contrôle de la position et de l'orientation des dômes, application des dômes sur l'élément, nettoyage puis application d'un nouveau ruban adhésif pour un nouveau cycle. Bien entendu, la tourelle peut avoir un autre nombre de faces ; en outre, une tourelle n'est pas indispensable. En effet, l'organe intermédiaire peut être simplement formé par un dispositif séparé de support passant à un poste de libération des dômes, à un poste de contrôle de positionnement, et à un poste d'application.

On a indiqué que l'organe intermédiaire 34 était formé d'un ruban adhésif. Dans ce cas, il est souhaitable que le ruban adhésif soit reporté sur l'élément de clavier 38 avec l'arrangement de dômes. Cependant, l'organe intermédiaire 34 peut aussi être simplement formé d'un organe souple de retenue par aspiration qui permet la retenue des dômes, puis leur positionnement direct dans des logements du circuit imprimé 38, lorsque le circuit imprimé 38 permet directement le positionnement des dômes. L'organe intermédiaire peut aussi placer les dômes avec l'arrangement voulu sur un organe adhésif utilisé pour une opération ultérieure.

## Revendications

1. Procédé de fabrication d'articles ayant un arrangement de pièces plates (10) réalisées par des étapes de découpe et de mise en forme d'un matériau en feuille, chaque pièce plate (10) comportant au moins une saillie (18, 20) destinée à empêcher le collage mutuel de deux pièces plates, le procédé comprenant les étapes suivantes :
le logement des pièces plates (10) dans des tubes de manière que, dans chaque tube, les pièces plates aient une même orientation dans le sens haut-bas et en rotation, chaque tube ayant une ouverture de sortie de pièce plate,
le positionnement de tubes contenant des pièces plates (10) afin qu'ils soient parallèles les uns aux autres et que leurs ouvertures de sortie soient disposées avec l'arrangement voulu pour les pièces plates dans l'article à réaliser, chaque tube étant orienté en rotation de manière que, au niveau de l'ouverture de sortie, les pièces plates aient l'orientation qu'elles doivent avoir dans l'article terminé ou une orientation inverse,
la saisie simultanée de pièces plates (10) par les ouvertures de sortie des tubes à raison d'une pièce plate par tube,
le déplacement des pièces plates saisies (10) soit directement sur un élément de l'article à fabriquer, soit sur un organe intermédiaire, avec la disposition que les pièces plates doivent avoir dans l'article terminé ou une disposition inverse, et
la libération des pièces plates (10).

2. Procédé selon la revendication 1, caractérisé en ce que la disposition des pièces plates (10) dans les tubes est réalisée dans des tubes de section complémentaire de la configuration périphérique des pièces plates de manière que toutes les pièces plates aient la même orientation dans le tube.

3. Procédé selon l'une des revendications 1 et 2, caractérisé en ce que chaque tube contient des pièces plates (10) d'un seul type, mais des tubes différents contiennent des pièces plates de types différents.

4. Procédé selon l'une quelconque des revendications précédentes, caractérisé en ce que la saisie, le déplacement et la libération des pièces plates (10) sont effectués par un dispositif (26) à aspiration.

5. Procédé selon l'une quelconque des revendications précédentes, caractérisé en ce que la libération des pièces plates (10) est effectuée lorsque celles-ci ont été appliquées sur une surface de maintien (34) des pièces plates avec l'arrangement voulu ou l'arrangement inverse sur un dispositif de maintien.

6. Procédé selon la revendication 5, caractérisé en ce que le dispositif de maintien (34) fonctionne par aspiration ou par collage.

7. Procédé selon l'une quelconque des revendications précédentes, caractérisé en ce qu'il comprend la libération des pièces plates (10) sur un organe intermédiaire de retenue (34), et le procédé comporte en outre la vérification du positionnement des pièces plates (10) sur l'organe de retenue (34) avant leur disposition dans l'article terminé.

8. Appareil automatique de positionnement de pièces plates, destiné à la mise en oeuvre du procédé selon l'une quelconque des revendications précédentes, du type qui comporte un gabarit de positionnement de tubes contenant des pièces plates (10), un dispositif de poussée de pièce, et un dispositif (26) de saisie, de déplacement et de libération de pièces, caractérisé en ce qu'il comporte une tourelle (30) à plusieurs faces, chaque face (32) portant un dispositif (34) de maintien de pièces plates avec l'arrangement voulu pour l'article terminé ou l'arrangement inverse, et un dispositif d'entraînement en rotation de la tourelle.

9. Appareil selon la revendication 8, caractérisé en ce qu'il comporte en outre un dispositif de vérification du positionnement des pièces plates (10) sur l'organe de maintien.

## Claims

1. A method of manufacturing articles having an arrangement of flat pieces (10) made by steps of cutting out and shaping from sheet material, each flat piece (10) having at least one projection (18, 20) designed to prevent two flat pieces sticking together, the method comprising the following steps:
flat pieces (10) are housed in tubes in such a manner that in each tube the flat pieces have the same orientation in the up-down direction and in rotation, each tube having an outlet opening for flat pieces;
the tubes containing the flat pieces (10) are positioned so as to be parallel to one another and so as to dispose their outlet openings in the arrangement desired for the flat pieces in the article that is to be made, each tube being oriented in rotation in such a manner that the flat pieces at the outlet opening of the tube have the orientation they are to have in the finished article, or the inverse orientation;
the flat pieces (10) are taken simultaneously from the outlet openings of the tubes, at a rate of one flat piece per tube;
the taken flat pieces (10) are displaced either directly onto an element of the article that is to be manufactured, or else onto an intermediate member, in the disposition that the flat pieces are to have in the finished article, or in an inverse disposition; and
the flat pieces (10) are released.

2. A method according to claim 1, characterized in that the flat pieces (10) are disposed in tubes of section complementary to the peripheral configuration of the flat pieces so that all of the flat pieces have the same orientation in a tube.

3. A method according to claim 1 or 2, characterized in that each tube contains flat pieces (10) of a single type, but different tubes contain flat pieces of different types.

4. A method according to any preceding claim, characterized in that the flat pieces (10) are taken, displaced, and released by a suction device (26).

5. A method according to any preceding claim, characterized in that the flat pieces (10) are released when the flat pieces have been applied to a holding surface on the holding device (34), in the desired arrangement or in the inverse arrangement.

6. A method according to claim 5, characterized in that the holding device (34) operates by suction or by adhesive.

7. A method according to any preceding claim, characterized in that it includes releasing flat pieces (10) on an intermediate retaining member (34), and the method further includes verifying the positioning of the flat pieces (10) on the retaining member (34) prior to positioning them in the finished article.

8. Automatic apparatus for positioning flat pieces and designed to implement the method according to any preceding claim, of the kind which includes a jig for positioning tubes containing flat pieces (10), a flat piece thrust device, and a device (26) for taking, displacing, and releasing flat pieces, characterized in that it includes a turret having a plurality of faces, each face (32) carrying a holding device (34) for holding flat pieces in the arrangement desired for the finished article or in the inverse arrangement, and a device for rotating the turret.

9. Apparatus according to claim 8, characterized in that it further includes a device for verifying the positioning of the flat pieces (10) on the holding member.

## Patentansprüche

1. Verfahren zur Herstellung von Artikeln, welche durch Zuschneiden und Formen eines Materialbogens hergestellte flächige Teile (10) in einer bestimmten Anordnung enthalten, wobei jedes flächige Teil (10) wenigstens einen Vorsprung (18, 20) umfaßt, der dazu dient, ein Zusammenhaften zweier flächiger Teile zu verhindern, und wobei das Verfahren die folgenden Arbeitsschritte enthält:
- Einfüllen von flächigen Teilen (10) in Röhren auf eine Weise, daß die flächigen Teile in jeder Röhre dieselbe Ausrichtung in bezug auf ihre Ober- und Unterseite sowie auf ihre Drehrichtung aufweisen, wobei jede Röhre eine Abgabeöffnung für die flächigen Teile enthält,
- Positionieren der die flächigen Teile (10) enthaltenden Röhren in einer Weise, daß die Röhren zueinander parallel verlaufen und ihre Abgabeöffnungen entsprechend der gewünschten Anordnung der flächigen Teile im herzustellenden Artikel zu liegen kommen, wobei jede Röhre durch Drehen so ausgerichtet wird, daß die flächigen Teile auf der Höhe der Abgabeöffnung die Ausrichtung besitzen, die sie auch im fertigen Artikel aufweisen sollen, bzw. daß sie eine hierzu spiegelverkehrte Ausrichtung besitzen,
- simultanes Ergreifen von flächigen Teilen (10) durch die Abgabeöffnungen der Röhren, so daß pro Röhre ein flächiges Teil abgegeben wird,
- Ablegen der ergriffenen flächigen Teile (10) entweder direkt auf einem Bauelement des herzustellenden Artikels oder auf einem Zwischenbauteil in der Anordnung, die die flächigen Teile im fertigen Artikel aufweisen sollen, bzw. in einer hierzu spiegelverkehrten Anordnung, und
- Freigeben der flächigen Teile (10).

2. Verfahren nach Anspruch 1, dadurch gekennzeichnet, daß die flächigen Teile (10) in Röhren angeordnet werden, deren Querschnitt der Randgestaltung der flächigen Teile komplementär ist, so daß alle flächigen Teile in einer Röhre dieselbe Ausrichtung aufweisen.

3. Verfahren nach einem der Ansprüche 1 und 2, dadurch gekennzeichnet, daß jede Röhre einen einzigen Typ von flächigen Teilen (10) enthält, wobei jedoch in den verschiedenen Röhren verschiedene Typen von flächigen Teilen enthalten sind.

4. Verfahren nach einem der vorangegangenen Ansprüche, dadurch gekennzeichnet, daß das Ergreifen, Ablegen und Freigeben der flächigen Teile (10) von einer Saugeinrichtung (26) durchgeführt wird.

5. Verfahren nach einem der vorangegangenen Ansprüche, dadurch gekennzeichnet, daß das Freigeben der flächigen Teile (10) erfolgt, sobald diese in der gewünschten bzw. einer hierzu spiegelbildlichen Anordnung auf eine an einer Positionshalteeinrichtung befindlichen Positionshaltefläche (34) für die flächigen Teile abgelegt wurden.

6. Verfahren nach Anspruch 5, dadurch gekennzeichnet, daß die Positionshalteeinrichtung (34) mittels Ansaugen bzw. Anhaften arbeitet.

7. Verfahren nach einem der vorangegangenen Ansprüche, dadurch gekennzeichnet, daß das Verfahren das Freigeben flächiger Teile (10) auf einem Zwischen-Halteelement (34) umfaßt und daß beim Verfahren unter anderem vor dem Anordnen der flächigen Teile im fertigen Artikel eine Überprüfung der Position der flächigen Teile (10) auf dem Zwischen-Halteelement (34) erfolgt.

8. Automatische Vorrichtung zur Positionierung von flächigen Teilen, welche bei der Durchführung des Verfahrens nach einem der vorangegangenen Ansprüche eingesetzt wird, enthaltend eine Positionierschablone für mit flächigen Teilen (10) bestückte Röhren, eine Einrichtung zum Verschieben der Teile sowie eine Einrichtung (26) zum Ergreifen, Ablegen und Freigeben der Teile, dadurch gekennzeichnet, daß die Vorrichtung einen Revolverkopf (30) mit mehreren Außenflächen umfaßt, wobei jede Außenfläche (32) eine Einrichtung (34) für die Positionshalterung der flächigen Teile enthält, die diese in der für den fertigen Artikel gewünschten Anordnung oder in einer hierzu spiegelbildlichen Anordnung haltert, und daß die Vorrichtung eine Einrichtung für den Drehantrieb des Revolverkopfes aufweist.

9. Vorrichtung nach Anspruch 8, dadurch gekennzeichnet, daß sie unter anderem eine Einrichtung zur Überprüfung der Position der flächigen Teile (10) auf dem Positionshalteelement umfaßt.
